# EUROPEAN PATENT APPLICATION

(11) **EP 4 439 672 A1**
(43) Date of publication of application: **02.10.2024**
(21) Application number: 23191581.0
(22) Date of filing: 16.08.2023
(51) Int. Cl.: H01L 29/06, H01L 29/08, H01L 29/78, H01L 21/336

(54) **SEMICONDUCTOR DEVICE AND METHOD FOR MANUFACTURING THE SAME**

(30) Priority: 27.03.2023 JP 2023049514
(71) Applicant: KABUSHIKI KAISHA TOSHIBA, Minato-ku Tokyo 105-0023 (JP); Toshiba Electronic Devices & Storage Corporation, Tokyo 105-0023 (JP)
(72) Inventor: KIYOSAWA, Tsutomu, Tokyo (JP)
(74) Representative: Kramer Barske Schmidtchen Patentanwälte PartG mbB

(57) **Abstract**

A semiconductor device according to an embodiment includes: a first electrode; a second electrode; a silicon carbide layer including a first silicon carbide region of a first conductive type including a first region, a second region having a higher first-conductive-type impurity concentration than the first region, and a third region between the second region and the first electrode, a second silicon carbide region of a second conductive type, a third silicon carbide region of the first conductive type, and a fourth silicon carbide region of the second conductive type between the first region and the second region; a gate electrode in the silicon carbide layer; and a gate insulating layer. The second region includes a first portion and a second portion. The second portion is between the first portion and the gate insulating layer, and has a lower first-conductive-type impurity concentration than a first-conductive-type impurity concentration of the first portion.

## Description

### CROSS-REFERENCE TO RELATED APPLICATION

This application is based upon and claims the benefit of priority from Japanese Patent Application No. 2023-049514, filed on March 27, 2023, the entire contents of which are incorporated herein by reference.

### FIELD

Embodiments described herein relate generally to a semiconductor device and a method for manufacturing the semiconductor device.

### BACKGROUND

Silicon carbide (SiC) is used as a material for a semiconductor device. Silicon carbide has excellent physical properties such as a band gap about 3 times wider, a breakdown field strength about 10 times higher, and a thermal conductivity about 3 times higher than those of silicon. These properties make it possible to realize, for example, a high-breakdown-voltage, low-loss, and high-temperature-operable metal-oxide semiconductor field-effect transistor (MOSFET).

A trench gate type MOSFET with a gate electrode formed in a trench realizes low on-resistance. The trench gate type MOSFET allows the channel area per unit area to increase and the on-resistance to be reduced.

It is desired to speed up the operation of a trench gate type MOSFET and further improve the transistor characteristics. To realize a high-speed, trench gate type MOSFET, for example, the gate-drain capacitance may be reduced.

### BRIEF DESCRIPTION OF THE DRAWINGS

FIG. 1 is a schematic diagram of a semiconductor device according to an embodiment;
FIG. 2 is a schematic diagram of the semiconductor device according to the embodiment;
FIG. 3 is a diagram that describes a method for manufacturing the semiconductor device according to the embodiment;
FIG. 4 is a diagram that describes the method for manufacturing the semiconductor device according to the embodiment;
FIG. 5 is a diagram that describes the method for manufacturing the semiconductor device according to the embodiment;
FIG. 6 is a diagram that describes the method for manufacturing the semiconductor device according to the embodiment;
FIG. 7 is a diagram that describes the method for manufacturing the semiconductor device according to the embodiment;
FIG. 8 is a diagram that describes the method for manufacturing the semiconductor device according to the embodiment;
FIG. 9 is a diagram that describes the method for manufacturing the semiconductor device according to the embodiment;
FIG. 10 is a diagram that describes the method for manufacturing the semiconductor device according to the embodiment;
FIG. 11 is a diagram that describes the method for manufacturing the semiconductor device according to the embodiment; and
FIG. 12 is a schematic diagram of a semiconductor device according to a modification example of the embodiment.

### DETAILED DESCRIPTION

A semiconductor device according to an embodiment includes: a first electrode; a second electrode; a silicon carbide layer provided between the first electrode and the second electrode, the silicon carbide layer including a first silicon carbide region of a first conductive type including a first region, a second region, and a third region, the second region provided between the first region and the first electrode, a first-conductive-type impurity concentration of the second region being higher than a first-conductive-type impurity concentration of the first region, and the third region provided between the second region and the first electrode, a second silicon carbide region of a second conductive type provided between the first silicon carbide region and the first electrode, a third silicon carbide region of the first conductive type provided between the second silicon carbide region and the first electrode, and a fourth silicon carbide region of the second conductive type provided between the first region and the second region; a gate electrode provided in the silicon carbide layer and facing the first silicon carbide region, the second silicon carbide region, the third silicon carbide region, and the fourth silicon carbide region; and a gate insulating layer provided between the first silicon carbide region and the gate electrode, between the second silicon carbide region and the gate electrode, between the third silicon carbide region and the gate electrode, and between the fourth silicon carbide region and the gate electrode, in which the second region includes a first portion and a second portion, the second portion is provided between the first portion and the gate insulating layer and between the fourth silicon carbide region and the third region, and a first-conductive-type impurity concentration of the second portion is lower than a first-conductive-type impurity concentration of the first portion.

Embodiments of the present disclosure will be described below with reference to the drawings. It is noted that in the following description, the same or similar members or somethings are assigned the same reference numeral, and description of the member or something that once has been described may be omitted accordingly.

Furthermore, in the following description, the notations "n⁺, n, n⁻" and "p⁺, p, p⁻" represent the relative levels of impurity concentration in respective conductive types. That is, n⁺ indicates a relatively higher n-type impurity concentration than n, and n⁻ indicates a relatively lower n-type impurity concentration than n. Furthermore, p⁺ indicates a relatively higher p-type impurity concentration than p, and p⁻ indicates a relatively lower p-type impurity concentration than p. It is noted that an n⁺-type and an n⁻-type may be simply referred to as an n-type; and a p⁺-type and a p⁻-type may be simply referred to as a p-type.

The impurity concentration can be measured by, for example, secondary ion mass spectrometry (SIMS). Furthermore, the relative level of the impurity concentration can be determined by, for example, the level of carrier concentration found by means of scanning capacitance microscopy (SCM). The distance, such as the width or the depth, of an impurity region can be found by means of, for example, SIMS. Furthermore, the distance, such as the width or the depth, of an impurity region can be found from, for example, an SCM image or a scanning electron microscope (SEM) image.

Respective thicknesses of substances constituting the semiconductor device and the distance between the substances can be measured on, for example, a SIMS image, a SEM image, or a transmission electron microscope (TEM) image.

It is noted that in the present specification, the "p-type impurity concentration" of a p-type silicon carbide region means the net p-type impurity concentration obtained by subtracting the n-type impurity concentration of the region from the p-type impurity concentration of the region. Furthermore, the "n-type impurity concentration" of an n-type silicon carbide region means the net n-type impurity concentration obtained by subtracting the p-type impurity concentration of the region from the n-type impurity concentration of the region.

Moreover, unless otherwise stated in the specification, the impurity concentration of a specific region means the maximum impurity concentration of the region.

A semiconductor device according to an embodiment includes: a first electrode; a second electrode; a silicon carbide layer provided between the first electrode and the second electrode, the silicon carbide layer including a first silicon carbide region of a first conductive type including a first region, a second region, and a third region, the second region provided between the first region and the first electrode, a first-conductive-type impurity concentration of the second region being higher than a first-conductive-type impurity concentration of the first region, and the third region provided between the second region and the first electrode, a second silicon carbide region of a second conductive type provided between the first silicon carbide region and the first electrode, a third silicon carbide region of the first conductive type provided between the second silicon carbide region and the first electrode, and a fourth silicon carbide region of the second conductive type provided between the first region and the second region; a gate electrode provided in the silicon carbide layer and facing the first silicon carbide region, the second silicon carbide region, the third silicon carbide region, and the fourth silicon carbide region; and a gate insulating layer provided between the first silicon carbide region and the gate electrode, between the second silicon carbide region and the gate electrode, between the third silicon carbide region and the gate electrode, and between the fourth silicon carbide region and the gate electrode. The second region includes a first portion and a second portion, the second portion is provided between the first portion and the gate insulating layer and between the fourth silicon carbide region and the third region, and a first-conductive-type impurity concentration of the second portion is lower than a first-conductive-type impurity concentration of the first portion.

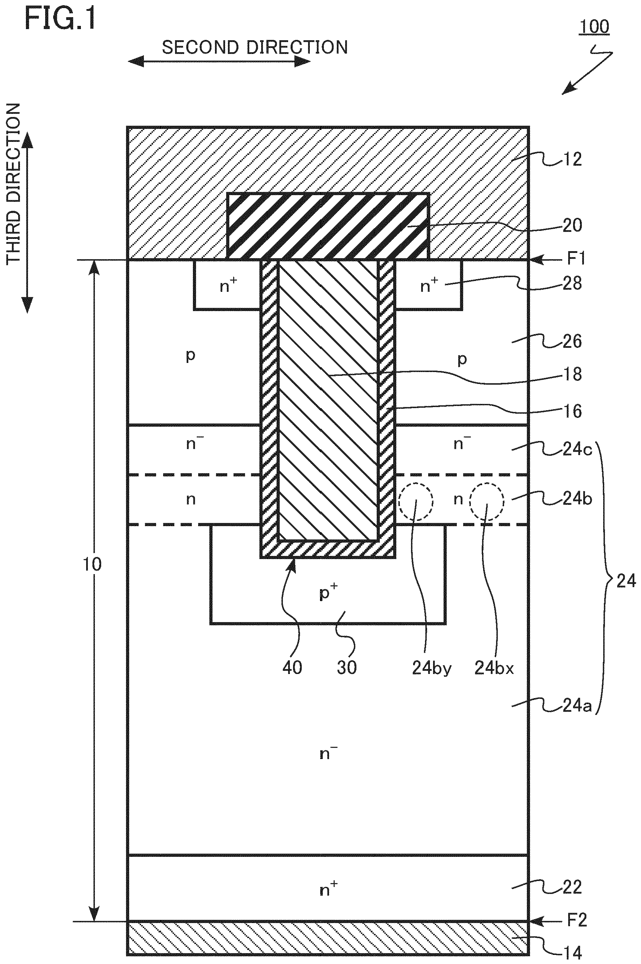

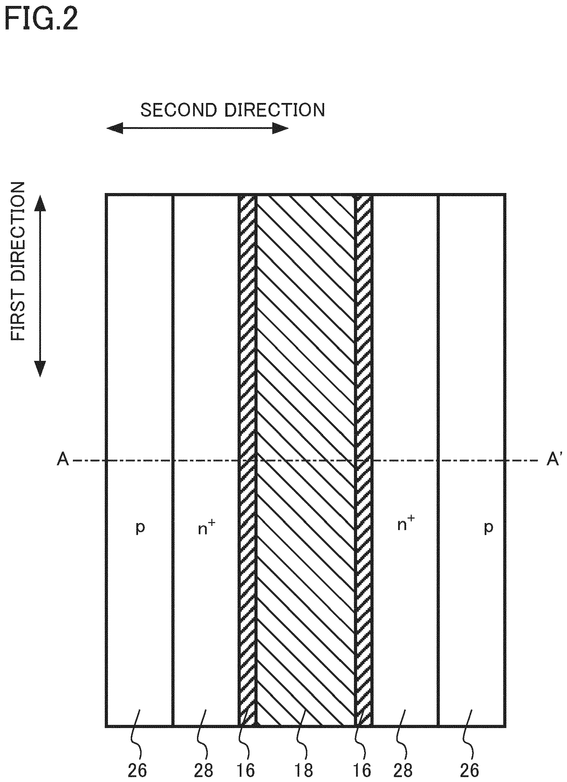

FIGS. 1 and 2 are schematic diagrams of a semiconductor device according to an embodiment. FIG. 1 is a schematic cross-sectional view of part of the semiconductor device according to the embodiment. FIG. 2 is a top view of the semiconductor device according to the embodiment. FIG. 2 shows the surface of a silicon carbide layer. FIG. 1 is a cross-sectional view of the semiconductor device along the line A-A' shown in FIG. 2.

The semiconductor device according to the embodiment is a vertical MOSFET 100 using silicon carbide. The MOSFET 100 is a trench gate type MOSFET with a gate electrode formed in a trench.

Below, a case where a first conductive type is the n-type, and a second conductive type is the p-type is described as an example. The MOSFET 100 is an n-channel MOSFET using electrons as carriers.

The MOSFET 100 includes a silicon carbide layer 10, a source electrode 12, a drain electrode 14, a gate insulating layer 16, a gate electrode 18, and an interlayer insulating layer 20. The source electrode 12 is an example of the first electrode. The drain electrode 14 is an example of the second electrode.

At least a portion of the silicon carbide layer 10 is provided between the source electrode 12 and the drain electrode 14. The silicon carbide layer 10 is single-crystal SiC. The silicon carbide layer 10 is, for example, 4H-SiC. The thickness of the silicon carbide layer 10 is, for example, equal to or more than 5 um and equal to or less than 150 µm.

The silicon carbide layer 10 has a first face ("F1" in FIG. 1) and a second face ("F2" in FIG. 1). Hereinafter, the first face F1 may be referred to as the surface, and the second face F2 may be referred to as the back surface. It is noted that in the following, the "depth" means the depth based on the first face F1.

In the following, a first direction and a second direction are directions parallel to the first face F1. The second direction is a direction perpendicular to the first direction. A third direction is a direction perpendicular to the first face F1. The third direction is a direction perpendicular to the first and second directions.

The first face F1 is a face of the silicon carbide layer 10 on the side of the source electrode 12. The second face F2 is a face of the silicon carbide layer 10 on the side of the drain electrode 14.

The first face F1 is, for example, a face inclined at an angle of equal to or more than 0 degrees and equal to or less than 8 degrees with respect to a (0001) face. Furthermore, the second face F2 is, for example, a face inclined at an angle of equal to or more than 0 degrees and equal to or less than 8 degrees with respect to a (000-1) face. The (0001) face is referred to as a silicon face. The (000-1) face is referred to as a carbon face.

The silicon carbide layer 10 includes an n⁺-type drain region 22, an n-type drift region 24, a p-type body region 26, an n⁺-type source region 28, a p⁺-type electric field relaxation region 30, and a trench 40.

The drift region 24 is an example of the first silicon carbide region. The body region 26 is an example of the second silicon carbide region. The source region 28 is an example of the third silicon carbide region. The electric field relaxation region 30 is an example of the fourth silicon carbide region.

The n⁺-type drain region 22 is provided on the side of the back surface of the silicon carbide layer 10. The drain region 22 contains, for example, nitrogen (N) as an n-type impurity. The n-type impurity concentration of the drain region 22 is, for example, equal to or more than 1 × 10¹⁸ cm⁻³ and equal to or less than 1 × 10²¹ cm⁻³.

The n-type drift region 24 is provided between the drain region 22 and the source electrode 12. The drift region 24 is provided between the drain region 22 and the first face F1. The drift region 24 is provided on the drain region 22. For example, the drift region 24 is in contact with the drain region 22.

The drift region 24 includes an n⁻-type first region 24a, an n-type second region 24b, and an n⁻-type third region 24c.

The n⁻-type first region 24a is provided between the drain region 22 and the source electrode 12. The first region 24a is provided between the drain region 22 and the first face F1. The first region 24a is in contact with the drain region 22.

The first region 24a is, for example, an epitaxial growth layer formed on the drain region 22 by an epitaxial growth method.

The first region 24a contains, for example, nitrogen (N) as an n-type impurity. The n-type impurity concentration of the first region 24a is lower than the n-type impurity concentration of the drain region 22. The n-type impurity concentration of the first region 24a is, for example, equal to or more than 5 × 10¹⁴ cm⁻³ and equal to or less than 5 × 10¹⁶ cm⁻³.

The thickness of the first region 24a in the third direction is, for example, equal to or more than 3 um and equal to or less than 150 µm.

The second region 24b is provided between the first region 24a and the source electrode 12. The second region 24b is provided between the first region 24a and the first face F1. The second region 24b is in contact with the first region 24a.

The second region 24b is, for example, an epitaxial growth layer formed on the first region 24a by the epitaxial growth method.

The second region 24b contains, for example, nitrogen (N) as an n-type impurity. The n-type impurity concentration of the second region 24b is higher than the n-type impurity concentration of the first region 24a. The n-type impurity concentration of the second region 24b is, for example, equal to or more than 1 × 10¹⁶ cm⁻³ and equal to or less than 1 × 10¹⁸ cm⁻³.

The thickness of the second region 24b in the third direction is thinner than the thickness of the first region 24a in the third direction. The thickness of the second region 24b in the third direction is, for example, equal to or more than 0.1 um and equal to or less than 0.5 µm.

The second region 24b includes a first portion 24bx and a second portion 24by. The second portion 24by is provided, in the second direction, between the first portion 24bx and the gate insulating layer 16. The second portion 24by is provided, in the second direction, between the first portion 24bx and the trench 40. Furthermore, the second portion 24by is provided, in the third direction, between the p⁺-type electric field relaxation region 30 and the third region 24c.

The first portion 24bx is disposed, in the third direction, between the first region 24a and the third region 24c. For example, the first portion 24bx is in contact with the first region 24a and the third region 24c.

The n-type impurity concentration of the second portion 24by is lower than the n-type impurity concentration of the first portion 24bx. The n-type impurity concentration of the second portion 24by is, for example, equal to or less than one-half of the n-type impurity concentration of the first portion 24bx.

For example, the n-type impurity concentration of the second portion 24by becomes higher from the electric field relaxation region 30 toward the third region 24c.

The second portion 24by contains aluminum. The first portion 24bx contains aluminum, or does not aluminum. For example, the concentration of aluminum contained in the second portion 24by is higher than the concentration of aluminum contained in the first portion 24bx.

For example, the concentration of aluminum contained in the second portion 24by becomes lower from the electric field relaxation region 30 toward the third region 24c.

The third region 24c is provided between the second region 24b and the source electrode 12. The third region 24c is provided between the second region 24b and the first face F1. The third region 24c is in contact with the second region 24b.

The third region 24c is, for example, an epitaxial growth layer formed on the second region 24b by the epitaxial growth method.

The third region 24c contains, for example, nitrogen (N) as an n-type impurity. For example, the n-type impurity concentration of the third region 24c is lower than the n-type impurity concentration of the second region 24b. The n-type impurity concentration of the third region 24c is, for example, equal to or more than 1 × 10¹⁵ cm⁻³ and equal to or less than 1 × 10¹⁸ cm⁻³.

The thickness of the third region 24c in the third direction is thinner than the thickness of the first region 24a in the third direction. The thickness of the third region 24c in the third direction is, for example, equal to or more than 0.1 um and equal to or less than 0.5 µm.

The p-type body region 26 is provided between the drift region 24 and the source electrode 12. The body region 26 is provided between the drift region 24 and the first face F1. For example, the body region 26 extends in the first direction as shown in FIG. 2. The body region 26 functions as a channel region of the MOSFET 100.

The body region 26 contains, for example, aluminum (Al) as a p-type impurity. The p-type impurity concentration of the body region 26 is, for example, equal to or more than 5 × 10¹⁶ cm⁻³ and equal to or less than 5 × 10¹⁸ cm⁻³.

The depth of the body region 26 is, for example, equal to or more than 0.5 um and equal to or less than 2 µm.

The n⁺-type source region 28 is provided between the body region 26 and the source electrode 12. The source region 28 is provided between the body region 26 and the first face F1. For example, the source region 28 extends in the first direction as shown in FIG. 2.

The source region 28 contains, for example, phosphorus (P) as an n-type impurity. The n-type impurity concentration of the source region 28 is higher than the n-type impurity concentration of the drift region 24. The n-type impurity concentration of the source region 28 is, for example, equal to or more than 1 × 10¹⁹ cm⁻³ and equal to or less than 5 × 10²¹ cm⁻³.

The depth of the source region 28 is shallower than the depth of the body region 26. The depth of the source region 28 is, for example, equal to or more than 0.1 um and equal to or less than 0.5 µm.

The p⁺-type electric field relaxation region 30 is provided in the drift region 24. The electric field relaxation region 30 is sandwiched, in the second direction, between a portion of the drift region 24 and another portion of the drift region 24.

The electric field relaxation region 30 is provided between the first region 24a and the second region 24b. The electric field relaxation region 30 is provided between the drift region 24 and the trench 40. The electric field relaxation region 30 is provided on the bottom of the trench 40.

The width of the electric field relaxation region 30 in the second direction is, for example, larger than the width of the trench 40 in the second direction.

The electric field relaxation region 30 has a function of relaxing an electric field applied to the gate insulating layer 16 on the bottom of the trench 40 when the MOSFET 100 is in OFF operation.

The electric field relaxation region 30 contains, for example, aluminum (Al) as a p-type impurity. For example, the p-type impurity concentration of the electric field relaxation region 30 is higher than the p-type impurity concentration of the body region 26. The p-type impurity concentration of the electric field relaxation region 30 is, for example, equal to or more than 5 × 10¹⁷ cm⁻³ and equal to or less than 5 × 10¹⁹ cm⁻³.

The trench 40 is provided on the side of the first face F1 of the silicon carbide layer 10. The trench 40 is a recess provided in the silicon carbide layer 10. The depth of the trench 40 is, for example, equal to or more than 1 um and equal to or less than 3 um. It is noted that in the MOSFET 100, more than one trenches 40 (not shown) are repeatedly disposed in the second direction.

The gate electrode 18 is provided in the silicon carbide layer 10. The gate electrode 18 is provided in the trench 40. The gate electrode 18 faces the drift region 24, the body region 26, the source region 28, and the electric field relaxation region 30.

For example, the gate electrode 18 extends in the first direction as shown in FIG. 2. It is noted that in the MOSFET 100, more than one gate electrodes 18 (not shown) are repeatedly disposed in the second direction.

The gate electrode 18 is, for example, polycrystal silicon containing a p-type impurity or an n-type impurity.

The gate insulating layer 16 is provided in the silicon carbide layer 10. The gate insulating layer 16 is provided in the trench 40. The gate insulating layer 16 is provided between the gate electrode 18 and the drift region 24, between the gate electrode 18 and the body region 26, between the gate electrode 18 and the source region 28, and between the gate electrode 18 and the electric field relaxation region 30.

The gate insulating layer 16 is in contact with the drift region 24. The gate insulating layer 16 is in contact with the second region 24b and the third region 24c. The gate insulating layer 16 is in contact with the body region 26, the source region 28, and the electric field relaxation region 30.

The gate insulating layer 16 is, for example, silicon oxide.

The interlayer insulating layer 20 is provided between the gate electrode 18 and the source electrode 12. The interlayer insulating layer 20 electrically isolates the gate electrode 18 and the source electrode 12. The interlayer insulating layer 20 is, for example, silicon oxide.

The source electrode 12 is provided on the side of the first face F1 of the silicon carbide layer 10. The source electrode 12 is in contact with the source region 28. The source electrode 12 is in contact with the body region 26.

The drain electrode 14 is provided on the side of the second face F2 of the silicon carbide layer 10. The drain electrode 14 is in contact with the drain region 22.

Subsequently, an example of a method for manufacturing the semiconductor device according to the embodiment is described. An example of a method for manufacturing a semiconductor device according to an embodiment includes: forming a second silicon carbide layer of a first conductive type on a first silicon carbide layer of the first conductive type by an epitaxial growth method, the second silicon carbide layer having a higher first-conductive-type impurity concentration than a first-conductive-type impurity concentration of the first silicon carbide layer; ion-implanting a second-conductive-type impurity into the first silicon carbide layer on a condition that does not allow a surface of the second silicon carbide layer to become a second conductive type and forming a first region of the second conductive type in the first silicon carbide layer; forming a third silicon carbide layer of the first conductive type on the second silicon carbide layer by the epitaxial growth method; ion-implanting a second-conductive-type impurity into the third silicon carbide layer and forming a second region of the second conductive type in the third silicon carbide layer; ion-implanting a first-conductive-type impurity into the second region and forming a third region of the first conductive type in the second region; forming a trench that goes through the third region and the second region and reaches the first region; forming a gate insulating layer in the trench; and forming a gate electrode on the gate insulating layer.

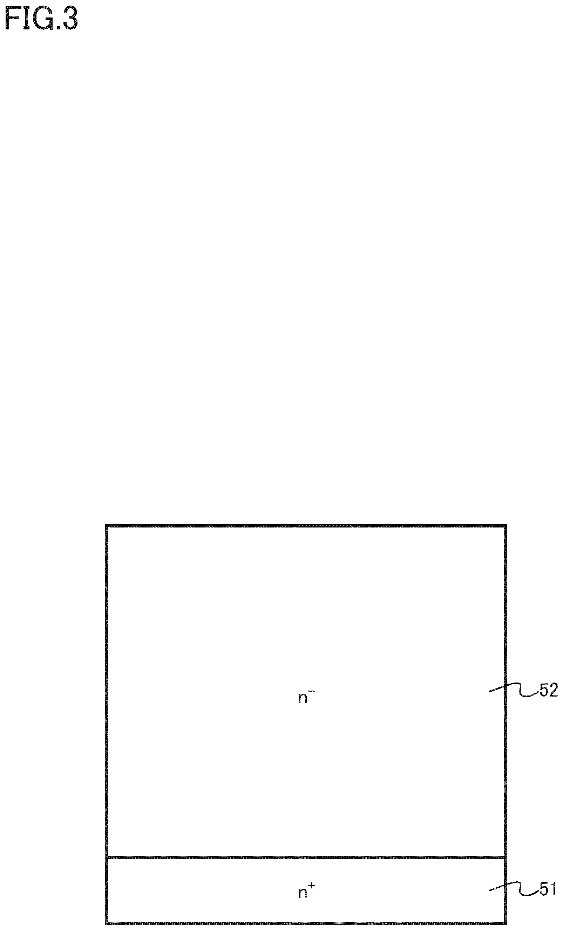

FIGS. 3 to 11 are diagrams that describe the method for manufacturing the semiconductor device according to the embodiment. FIGS. 3 to 11 are schematic cross-sectional views showing a process of manufacturing the semiconductor device according to the embodiment. FIGS. 3 to 11 show a cross section corresponding to FIG. 1.

First, an n⁻-type first silicon carbide layer 52 is formed on an n⁺-type substrate layer 51 (FIG. 3). The substrate layer 51 is, for example, a silicon carbide wafer. The first silicon carbide layer 52 is formed, for example, on the substrate layer 51 by the epitaxial growth method. The first silicon carbide layer 52 is an epitaxial growth layer. The first silicon carbide layer 52 eventually becomes the first region 24a of the drift region 24.

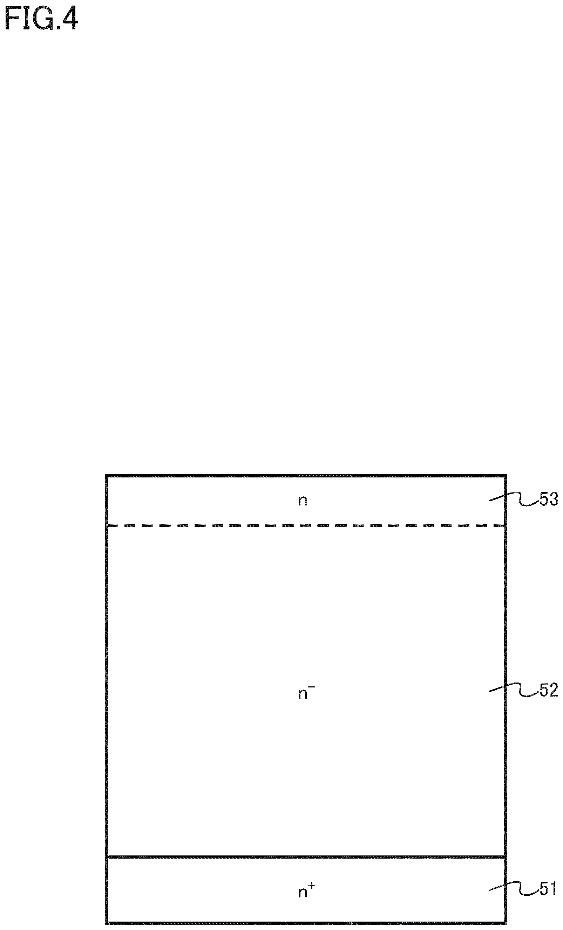

Next, an n-type second silicon carbide layer 53 is formed on the first silicon carbide layer 52 (FIG. 4). The second silicon carbide layer 53 is formed on the first silicon carbide layer 52 by the epitaxial growth method. The second silicon carbide layer 53 is an epitaxial growth layer. The n-type impurity concentration of the second silicon carbide layer 53 is higher than the n-type impurity concentration of the first silicon carbide layer 52.

For example, the first silicon carbide layer 52 and the second silicon carbide layer 53 are continuously formed in a reaction chamber of an epitaxial growth system.

The second silicon carbide layer 53 eventually becomes the second region 24b of the drift region 24.

Next, a first mask material 54 is formed on the second silicon carbide layer 53. The first mask material 54 is formed by, for example, deposition of a film by a chemical vapor deposition (CVD) method and patterning of the film by a photolithography method and a reactive ion etching (RIE) method. The first mask material 54 is, for example, silicon oxide.

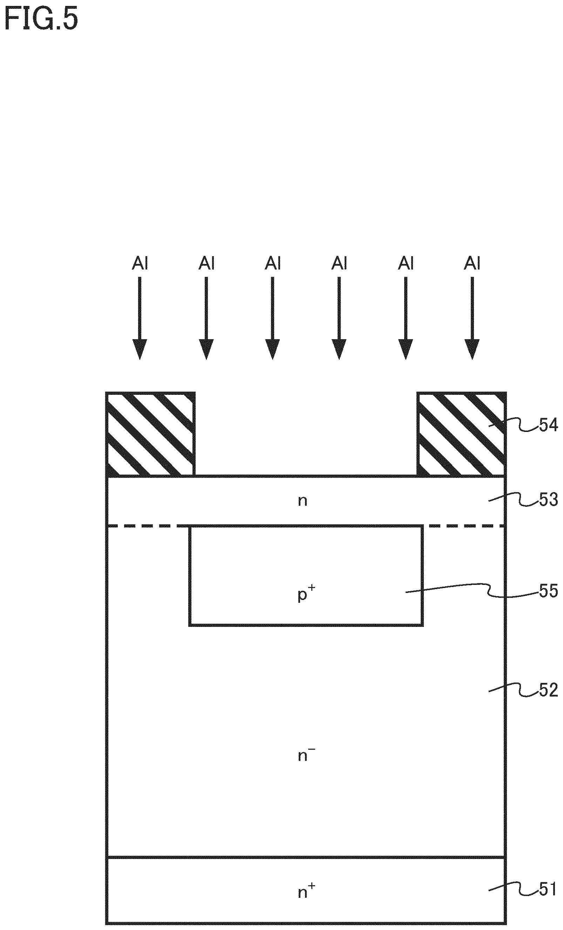

Next, with the first mask material 54 as a mask, aluminum (Al) is ion-implanted into the first silicon carbide layer 52 to form a p⁺-type first SiC region 55 in the first silicon carbide layer 52 (FIG. 5). The first SiC region 55 is an example of the first region.

At the time of ion implantation of aluminum, the ion implantation is performed on a condition that does not allow the surface of the second silicon carbide layer 53 to become the p-type. By appropriately setting the dose and the acceleration energy of the ion implantation of aluminum, the surface of the second silicon carbide layer 53 is not changed from the n-type to the p-type.

It is noted that as a result of the ion implantation of aluminum, the second silicon carbide layer 53 on the first SiC region 55 contains aluminum. The concentration of aluminum contained in the second silicon carbide layer 53 becomes lower toward the surface of the second silicon carbide layer 53.

The first SiC region 55 eventually becomes the electric field relaxation region 30.

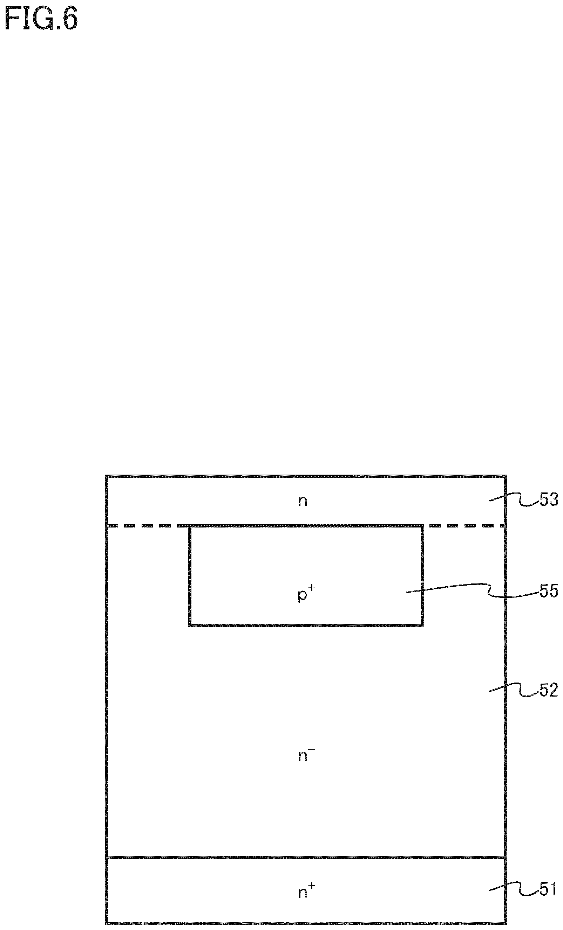

Next, the first mask material 54 is removed (FIG. 6). The first mask material 54 is removed by, for example, a wet etching method.

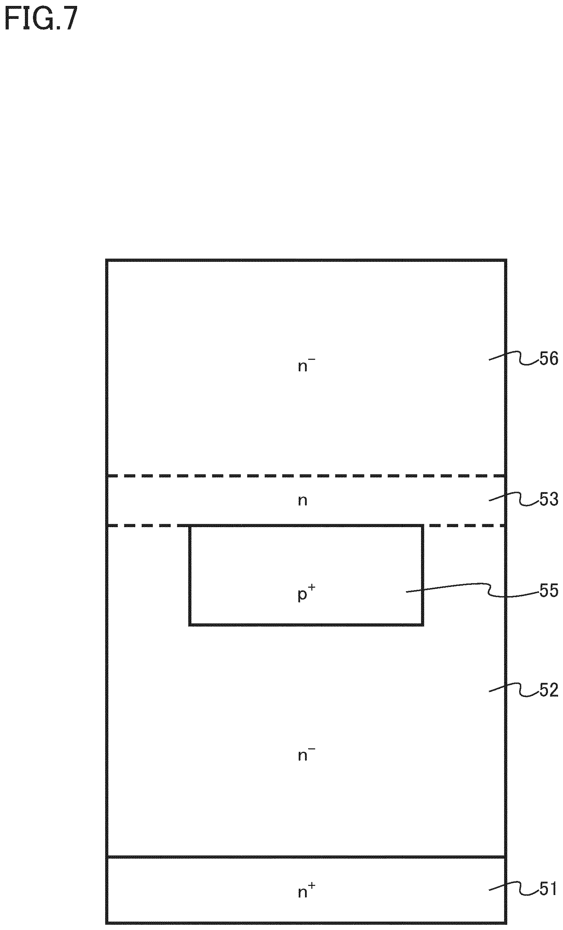

Next, an n⁻-type third silicon carbide layer 56 is formed on the second silicon carbide layer 53 (FIG. 7). The third silicon carbide layer 56 is formed on the second silicon carbide layer 53 by the epitaxial growth method. The third silicon carbide layer 56 is an epitaxial growth layer. For example, the n-type impurity concentration of the third silicon carbide layer 56 is lower than the n-type impurity concentration of the second silicon carbide layer 53.

A hydrogen etching process is performed before the formation of the third silicon carbide layer 56. The hydrogen etching process is performed in the reaction chamber of the epitaxial growth system that forms the third silicon carbide layer 56.

The hydrogen etching process is performed in an atmosphere containing hydrogen. The temperature of the hydrogen etching process is, for example, equal to or more than 1500°C and equal to or less than 1650°C. The hydrogen etching process is a process of cleaning the surface of the second silicon carbide layer 53. Through the hydrogen etching process, for example, a natural oxide film on the surface of the second silicon carbide layer 53 is removed.

Subsequently to the hydrogen etching process, the third silicon carbide layer 56 is formed on the second silicon carbide layer 53. The heat treatment temperature at the time of the formation of the third silicon carbide layer 56 is, for example, equal to or more than 1500°C and equal to or less than 1650°C.

The third silicon carbide layer 56 eventually becomes the third region 24c of the drift region 24, the body region 26, and the source region 28.

It is noted that activation annealing for activating aluminum ion-implanted into the first SiC region 55 is not performed before the formation of the third silicon carbide layer 56. The activation of aluminum ion-implanted into the first SiC region 55 is substituted by the hydrogen etching process or the heat treatment associated with the formation of the third silicon carbide layer 56. In other words, an activation annealing step is omitted.

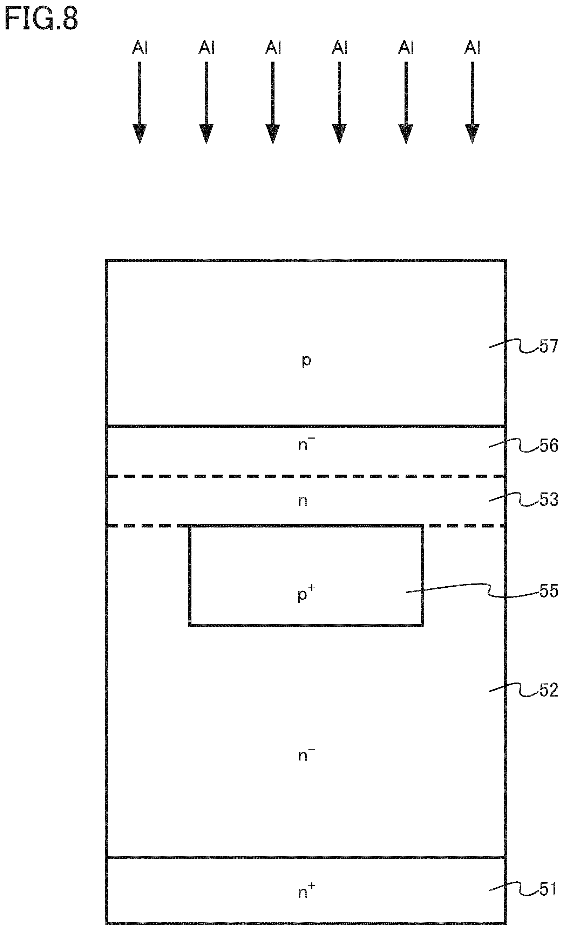

Next, aluminum (Al) is ion-implanted into the third silicon carbide layer 56 to form a p-type second SiC region 57 in the third silicon carbide layer 56 (FIG. 8). The second SiC region 57 is an example of the second region. The second SiC region 57 eventually becomes the p-type body region 26.

Next, a second mask material 58 is formed on the second SiC region 57. The second mask material 58 is formed by, for example, deposition of a film by the CVD method and patterning of the film by the photolithography method and the RIE method. The second mask material 58 is, for example, silicon oxide.

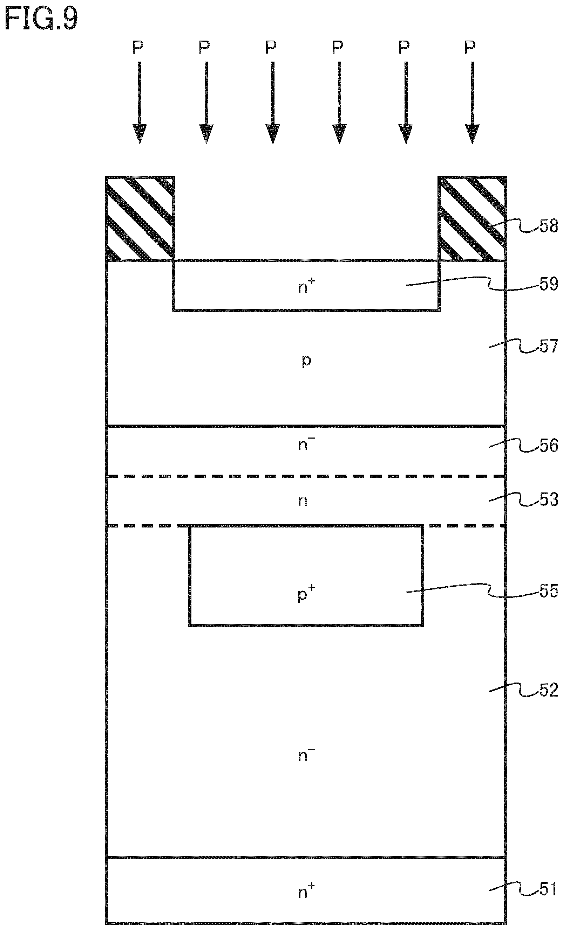

Next, with the second mask material 58 as a mask, phosphorus (P) is ion-implanted into the second SiC region 57 to form an n⁺-type third SiC region 59 in the second SiC region 57 (FIG. 9). The third SiC region 59 is an example of the third region. The third SiC region 59 eventually becomes the source region 28.

Next, the second mask material 58 is removed. Next, a third mask material 60 is formed on the second SiC region 57 and the third SiC region 59. The third mask material 60 is formed by, for example, deposition of a film by the CVD method and patterning of the film by the photolithography method and the RIE method. The third mask material 60 is, for example, silicon oxide.

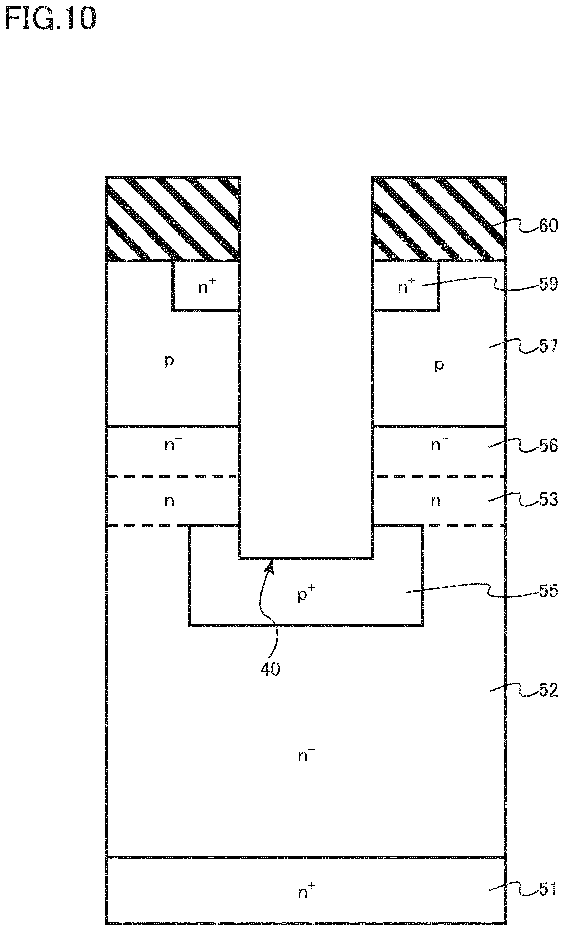

Next, with the third mask material 60 as a mask, the trench 40 that goes through the third SiC region 59 and the second SiC region 57 and reaches the first SiC region 55 is formed (FIG. 10). The trench 40 is formed by, for example, the RIE method.

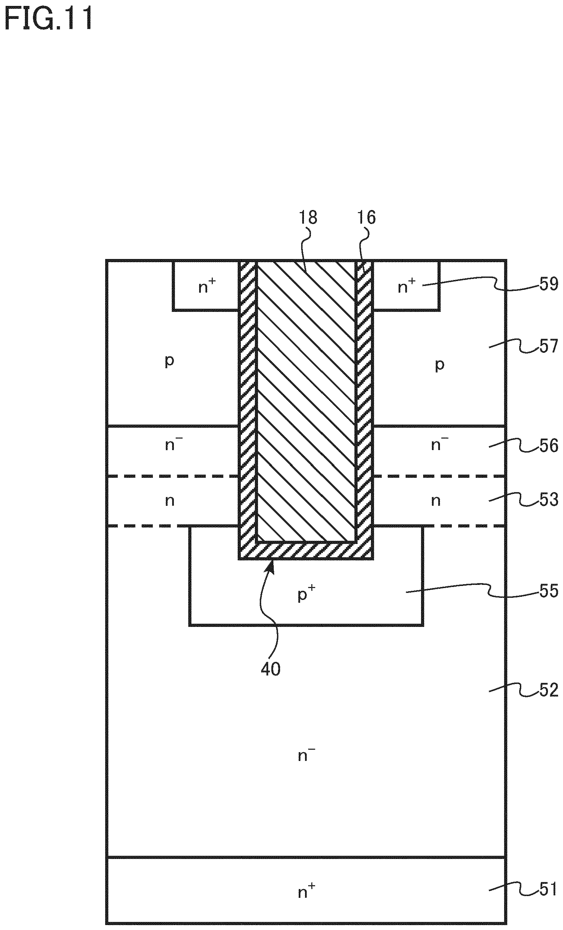

Next, the third mask material 60 is removed. Next, by using known process technology, the gate insulating layer 16 is formed in the trench 40, and the gate electrode 18 is formed on the gate insulating layer 16 (FIG. 11).

After that, by using known process technology, the source electrode 12 and the drain electrode 14 are formed.

By the above manufacturing method, the MOSFET 100 shown in FIGS. 1 and 2 is formed.

Subsequently, the function and effect of the semiconductor device and its manufacturing method according to the embodiment are described.

A trench gate type MOSFET with a gate electrode formed in a trench realizes low on-resistance. The trench gate type MOSFET allows the channel area per unit area to increase and the on-resistance to be reduced.

The MOSFET 100 according to the embodiment is a trench gate type MOSFET. The MOSFET 100 includes the second region 24b having the higher n-type impurity concentration than the n-type impurity concentration of the first region 24a between the p-type body region 26 and the p⁺-type electric field relaxation region 30 and between the p-type body region 26 and the first region 24a of the drift region 24.

In the MOSFET 100, the second region 24b having the high n-type impurity concentration functions as a current spreading layer, which further reduces the on-resistance. That is, when the MOSFET 100 is in ON operation, carriers flow from the source region 28 into the drift region 24 through a channel region formed in the body region 26 near the side surface of the trench 40. The carriers flown into the drift region 24 are diffused in a lateral direction (the second direction in FIG. 1) along the low-resistance second region 24b. Therefore, a pathway through which the carriers flow expands in the drift region 24, and the on-resistance of the MOSFET 100 is reduced.

Meanwhile, if the n-type impurity concentration of the drift region 24 facing the gate electrode 18 becomes too high, the gate-drain capacitance increases, and there is a possibility that the operating speed of the MOSFET 100 may be reduced.

In the MOSFET 100 according to the embodiment, the second region 24b functioning as a current spreading layer includes the first portion 24bx and the second portion 24by closer to the gate electrode 18 than the first portion 24bx. The n-type impurity concentration of the second portion 24by is lower than the n-type impurity concentration of the first portion 24bx. The n-type impurity concentration of the drift region 24 facing the gate electrode 18 is partially lowered, thus the gate-drain capacitance of the MOSFET 100 is reduced. This prevents the reduction of the operating speed of the MOSFET 100, which makes it possible to realize the high-speed MOSFET 100.

From the viewpoint of reducing the gate-drain capacitance, the n-type impurity concentration of the second portion 24by is preferably equal to or less than one-half, more preferably equal to or less than one-fifth, and still more preferably equal to or less than one-tenth of the n-type impurity concentration of the first portion 24bx.

For example, if a silicon carbide layer is formed by the epitaxial growth method on a p-type silicon carbide layer that aluminum exists in high concentration on its surface, a reaction chamber of an epitaxial growth system is contaminated with aluminum. The contamination with aluminum is caused, particularly, at the time of a hydrogen etching process performed prior to the formation of the silicon carbide layer, by the surface of the p-type silicon carbide layer being etched.

If the reaction chamber of the epitaxial growth system is contaminated with aluminum, particularly, in a case of forming a low-concentration n-type silicon carbide layer, aluminum that is a p-type impurity is mixed into the n-type silicon carbide layer, and it becomes difficult to control the n-type impurity concentration.

Furthermore, if a silicon carbide layer is formed by the epitaxial growth method on a silicon carbide layer with a p-type region formed by ion implantation of high-dose aluminum present on its surface, the crystallinity of the silicon carbide layer degrades. This can be because defects caused by the ion implantation exist in high density in the p-type region.

If the crystallinity of the silicon carbide layer degrades, there is a possibility that properties degradation, such as an increase in junction leakage, may occur in the MOSFET.

In the method for manufacturing the semiconductor device according to the embodiment, to form the p⁺-type electric field relaxation region 30, the p⁺-type first SiC region 55 is formed in the first silicon carbide layer 52. Before ion implantation of aluminum is performed to form the first SiC region 55, the surface of the first silicon carbide layer 52 is covered with the second silicon carbide layer 53 having the higher n-type impurity concentration than the first silicon carbide layer 52. Then, the ion implantation is performed on a condition that does not allow the surface of the second silicon carbide layer 53 to become the p-type. After that, the third silicon carbide layer 56 is formed on the second silicon carbide layer 53 by the epitaxial growth method.

In the method for manufacturing the semiconductor device according to the embodiment, the surface of the second silicon carbide layer 53 is the n-type, and the reaction chamber of the epitaxial growth system is prevented from being contaminated with aluminum.
Therefore, it becomes easy for the epitaxial growth system to control the n-type impurity concentration of the silicon carbide layer.

Furthermore, in the method for manufacturing the semiconductor device according to the embodiment, the surface of the second silicon carbide layer 53 is the n-type, and there is no p-type region formed by ion implantation of high-dose aluminum. This prevents the degradation of the crystallinity of the third silicon carbide layer 56 formed on the second silicon carbide layer 53. Therefore, the properties degradation of the MOSFET 100 is prevented.

Moreover, in the method for manufacturing the semiconductor device according to the embodiment, it is possible to omit the activation annealing step with respect to the p⁺-type first SiC region 55 before the formation of the third silicon carbide layer 56.

Here is a case where a silicon carbide layer is formed by the epitaxial growth method on a silicon carbide layer with a p-type region formed by ion implantation of high-dose aluminum present on its surface without the activation annealing step. In this case, for example, when the temperature of the hydrogen etching process rises, there is a possibility that the wafer may be deformed and pop out of a wafer holder in the epitaxial growth system. The deformation of the wafer can be caused by ion implantation damage to the p-type region exposed on the wafer surface.

In the method for manufacturing the semiconductor device according to the embodiment, the surface of the second silicon carbide layer 53 is the n-type, and the p-type region formed by ion implantation of high-dose aluminum is not exposed on the surface. Therefore, when the temperature of the hydrogen etching process rises, the wafer is prevented from being deformed and popping out. Thus, it is possible to omit the activation annealing step with respect to the p⁺-type first SiC region 55.

### (Modification Example)

A semiconductor device according to a modification example of the embodiment differs from the semiconductor device according to the embodiment in that the first-conductive-type impurity concentration of the third region is higher than the first-conductive-type impurity concentration of the second region. Furthermore, a method for manufacturing the semiconductor device according to the modification example of the embodiment differs from the method for manufacturing the semiconductor device according to the embodiment in that the first-conductive-type impurity concentration of the third silicon carbide layer is higher than the first-conductive-type impurity concentration of the second silicon carbide layer.

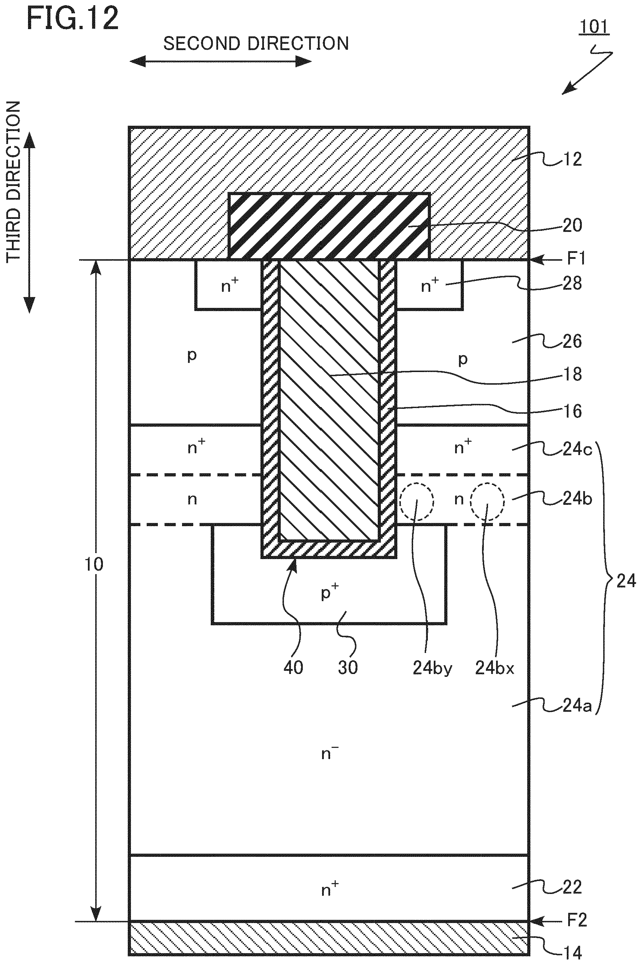

FIG. 12 is a schematic diagram of the semiconductor device according to the modification example of the embodiment. FIG. 12 is a schematic cross-sectional view of part of the semiconductor device according to the modification example of the embodiment. FIG. 12 is a diagram corresponding to FIG. 1 for the embodiment.

The semiconductor device according to the modification example of the embodiment is a vertical MOSFET 101 using silicon carbide. The MOSFET 101 is a trench gate type MOSFET with a gate electrode formed in a trench.

The drift region 24 of the MOSFET 101 includes the n⁻-type first region 24a, the n-type second region 24b, and an n⁺-type third region 24c.

The third region 24c contains, for example, nitrogen (N) as an n-type impurity. For example, the n-type impurity concentration of the third region 24c is higher than the n-type impurity concentration of the second region 24b. The n-type impurity concentration of the third region 24c is, for example, equal to or more than 2 × 10¹⁶ cm⁻³ and equal to or less than 2 × 10¹⁸ cm⁻³.

The MOSFET 101 can be manufactured by a manufacturing method similar to that of the MOSFET 100 according to the embodiment. However, the n-type impurity concentration of the third silicon carbide layer 56 is higher than the n-type impurity concentration of the second silicon carbide layer 53.

In the MOSFET 101 according to the modification example of the embodiment, the third region 24c having the high n-type impurity concentration also functions as a current spreading layer. Therefore, the on-resistance is further reduced.

The n-type impurity concentration of the third region 24c can be equal to the n-type impurity concentration of the second region 24b.

As described above, according to the semiconductor device and its manufacturing method according to the embodiment and its modification example, the gate-drain capacitance is reduced, which makes it possible to speed up the operation of the MOSFET. Furthermore, the method for manufacturing the semiconductor device according to the embodiment and its modification example can prevent the contamination of the reaction chamber of the epitaxial growth system and the properties degradation of the MOSFET, and omit the activation annealing step.

In the embodiment, there is described the case of using 4H-SiC as the crystal structure of SiC an example; however, the present disclosure can also be applied to devices using SiC of other crystal structures, such as 6H-SiC and 3C-SiC. Furthermore, a face other than the (0001) face can be used as the surface of the silicon carbide layer 10.

In the embodiment, there is described the case where the first conductive type is the n-type, and the second conductive type is the p-type as an example; however, the first conductive type can be the p-type, and the second conductive type can be the n-type.

In the embodiment, aluminum (Al) is provided as an example of a p-type impurity; however, boron (B) can also be used. Furthermore, nitrogen (N) and phosphorus (P) are provided as an example of an n-type impurity; however, for example, arsenic (As) or antimony (Sb) can also be used.

While certain embodiments have been described, these embodiments have been presented by way of example only, and are not intended to limit the scope of the inventions. Indeed, the semiconductor device and the method for manufacturing the semiconductor device described herein may be embodied in a variety of other forms; furthermore, various omissions, substitutions and changes in the form of the devices and methods described herein may be made without departing from the spirit of the inventions. The accompanying claims and their equivalents are intended to cover such forms or modifications as would fall within the scope and spirit of the inventions.

It is explicitly stated that all features disclosed in the description and/or the claims are intended to be disclosed separately and independently from each other for the purpose of original disclosure as well as for the purpose of restricting the claimed invention independent of the composition of the features in the embodiments and/or the claims. It is explicitly stated that all value ranges or indications of groups of entities disclose every possible intermediate value or intermediate entity for the purpose of original disclosure as well as for the purpose of restricting the claimed invention, in particular as limits of value ranges.

## Claims

1. A semiconductor device (100,101) comprising:
a first electrode (12);
a second electrode (14);
a silicon carbide layer (10) provided between the first electrode (12) and the second electrode (14), the silicon carbide layer (10) including
a first silicon carbide region (24) of a first conductive type including a first region (24a), a second region (24b), and a third region (24c), the second region (24b) provided between the first region (24a) and the first electrode (12), a first-conductive-type impurity concentration of the second region (24b) being higher than a first-conductive-type impurity concentration of the first region (24a), and the third region (24c) provided between the second region (24b) and the first electrode (12),
a second silicon carbide region (26) of a second conductive type provided between the first silicon carbide region (24) and the first electrode (12),
a third silicon carbide region (28) of the first conductive type provided between the second silicon carbide region (26) and the first electrode (12), and
a fourth silicon carbide region (30) of the second conductive type provided between the first region (24a) and the second region (24b);
a gate electrode (18) provided in the silicon carbide layer (10) and facing the first silicon carbide region (24), the second silicon carbide region (26), the third silicon carbide region (28), and the fourth silicon carbide region (30); and
a gate insulating layer (16) provided between the first silicon carbide region (24) and the gate electrode (18), between the second silicon carbide region (26) and the gate electrode (18), between the third silicon carbide region (28) and the gate electrode (18), and between the fourth silicon carbide region (30) and the gate electrode (18),
wherein
the second region (24b) includes a first portion (24bx) and a second portion (24by),
the second portion (24by) is provided between the first portion (24bx) and the gate insulating layer (16) and between the fourth silicon carbide region (30) and the third region (24c), and
a first-conductive-type impurity concentration of the second portion (24by) is lower than a first-conductive-type impurity concentration of the first portion (24bx).

2. The semiconductor device (100) according to claim 1, wherein a first-conductive-type impurity concentration of the third region (24c) is lower than the first-conductive-type impurity concentration of the second region (24b).

3. The semiconductor device (100,101) according to claim 1 or 2, wherein the first conductive type is an n-type, and the second conductive type is a p-type, and a concentration of aluminum contained in the second portion (24by) is higher than a concentration of aluminum contained in the first portion (24bx).

4. The semiconductor device (100,101) according to claim 3, wherein the concentration of aluminum contained in the second portion (24by) becomes lower from the fourth silicon carbide region (30) toward the third region (24c).

5. The semiconductor device (101) according to claim 1, wherein a first-conductive-type impurity concentration of the third region (24c) is higher than the first-conductive-type impurity concentration of the second region (24b).

6. A method for manufacturing a semiconductor device (100,101), the method comprising:
forming a second silicon carbide layer (53) of a first conductive type on a first silicon carbide layer (52) of the first conductive type by epitaxial growth method, a first-conductive-type impurity concentration of the second silicon carbide layer (53) being higher than a first-conductive-type impurity concentration of the first silicon carbide layer (52);
forming a first region (55) of the second conductive type in the first silicon carbide layer (52), the first region (55) being formed by ion-implanting a second-conductive-type impurity into the first silicon carbide layer (52) on a condition that does not allow a surface of the second silicon carbide layer (53) to become a second conductive type and;
forming a third silicon carbide layer (56) of the first conductive type on the second silicon carbide layer (53) by epitaxial growth method;
forming a second region (57) of the second conductive type in the third silicon carbide layer (56), the second region (57) being formed by ion-implanting a second-conductive-type impurity into the third silicon carbide layer (56);
forming a third region (59) of the first conductive type in the second region (57), the third region (59) being formed by ion-implanting a first-conductive-type impurity into the second region (57);
forming a trench (40) penetrating the third region (59) and the second region (57) and reaching the first region (55);
forming a gate insulating layer (16) in the trench (40); and
forming a gate electrode (18) on the gate insulating layer (16).

7. The method for manufacturing the semiconductor device (100) according to claim 6, wherein a first-conductive-type impurity concentration of the third silicon carbide layer (56) is lower than the first-conductive-type impurity concentration of the second silicon carbide layer (53).

8. The method for manufacturing the semiconductor device (101) according to claim 6, wherein a first-conductive-type impurity concentration of the third silicon carbide layer (56) is higher than the first-conductive-type impurity concentration of the second silicon carbide layer (53).
